# EUROPEAN PATENT APPLICATION

(11) **EP 4 696 737 A1**
(43) Date of publication of application: **18.02.2026**
(21) Application number: 24788515.5
(22) Date of filing: 15.03.2024
(51) Int. Cl.: C08G 77/18

(54) **ORGANOPOLYSILOXANE COMPOUND**

(30) Priority: 11.04.2023 JP 2023064230
(71) Applicant: SHIN-ETSU CHEMICAL CO., LTD., Tokyo 1000005 (JP)
(72) Inventor: NISHIMURA, Issei, Annaka-shi, Gunma 379-0224 (JP); ENDO, Akihiro, Annaka-shi, Gunma 379-0224 (JP); ITO, Takanori, Annaka-shi, Gunma 379-0224 (JP)
(74) Representative: Schicker, Silvia
(86) International application number: PCT/JP2024/010323
(87) International publication number: WO 2024/214485

(57) **Abstract**

The present invention is an organopolysiloxane compound represented by the general formula (1), wherein R¹ independently represents an aromatic hydrocarbon group having 6 to 10 carbon atoms; R² independently represents an alkyl group having 1 to 10 carbon atoms; R³ represents an alkyl group having 1 to 4 carbon atoms; "a" represents 2 or 3; and "n" represents an integer satisfying 2≤n≤60. This can provide a novel organopolysiloxane compound that acts as a wetter that allows a phenyl-modified silicone to be highly filled with a highly thermally conductive filler.

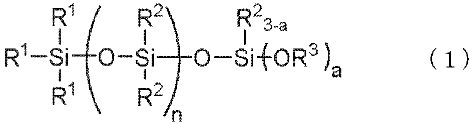

## Description

### TECHNICAL FIELD

The present invention relates to an organopolysiloxane compound.

### BACKGROUND ART

An electronic component, such as a highly integrated circuit like CPU, generates heat during use, which significantly reduces its performance. To solve this problem, a heat dissipation material is used to efficiently transfer heat by being introduced into an air gap between a heat-generating part and a cooling part. Among these, a silicone heat dissipation material is used in a wide range of fields because it has high heat resistance, weather resistance, and electric insulation, which are inherent to silicone. In addition, as an electronic device has become increasingly miniaturized and highly integrated in recent years, it is important to be able to cool the generated heat more efficiently, which has led to a demand for heat dissipation materials with high thermal conductivity.

Thermal conductivity of materials containing silicone oil and thermally conductive filler is affected by thermal conductivity of the thermally conductive filler itself when a volume fraction of the thermally conductive filler exceeds 0.6. Therefore, to increase the thermal conductivity of the heat dissipation material, it is important to achieve highly filling of the thermally conductive filler. However, simply increasing the filling thereof significantly reduces flowability of the heat-conductive grease, resulting in poor workability. To solve this problem, a method has been proposed in which the thermally conductive filler is surface-treated with a silane coupling agent (wetter) and dispersed in the silicone base oil, thereby maintaining the flowability of the heat-conductive grease.

Phenyl-modified silicones, which have a structure in which part of methylsilicones have been substituted with a phenyl group, have better heat resistance, cold resistance, and oxidation resistance than methylsilicones. Furthermore, because they have high gas barrier properties and a high refractive index, the phenyl-modified silicones are applied to cosmetics, encapsulant for a light-emitting diode, etc. (Patent Documents 1 and 2). Therefore, by applying the phenyl-modified silicone to the heat dissipation material as a base oil, it is expected that properties that cannot be achieved with methyl silicone can be achieved. However, the introduction of the phenyl group makes a silicone skeleton rigid, which causes a problem of a significant increase in viscosity, especially in highly phenyl-modified silicones (Patent Document 3).

Therefore, when thermally conductive filler is added to a base oil of the phenyl-modified silicone to form a grease, the flowability of the resultant heat-conductive grease is significantly reduced. Furthermore, organopolysiloxane having a trialkoxysilyl group, which are commonly used as a wetter, has poor solubility in the phenyl-modified silicones (Patent Documents 4 and 5). Therefore, there has been a need for development of a wetter that exhibits highly soluble in the phenyl-modified silicones and can prevent its viscosity from increasing when the thermally conductive filler is added.

### CITATION LIST

### PATENT LITERATURE

Patent Document 1: JP2004-162039A
Patent Document 2: JP2007-039621A
Patent Document 3: JP2004-262919A
Patent Document 4: JP2004-262972A
Patent Document 5: JP2005-162975A

### SUMMARY OF INVENTION

### TECHNICAL PROBLEM

An object of the present invention is to provide a novel organopolysiloxane compound that acts as a wetter that allows a resin material, particularly a phenyl-modified silicone, to be highly filled with a highly thermally conductive filler.

### SOLUTION TO PROBLEM

In order to achieve the above object, the present invention provides the following organopolysiloxane compound.

That is, the present invention provides an organopolysiloxane compound represented by the following general formula (1), 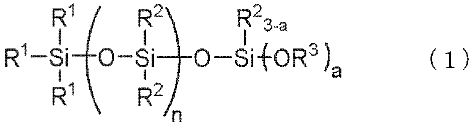 wherein R¹ independently represents an aromatic hydrocarbon group having 6 to 10 carbon atoms; R² independently represents an alkyl group having 1 to 10 carbon atoms; R³ represents an alkyl group having 1 to 4 carbon atoms; "a" represents 2 or 3; and "n" represents an integer satisfying 2≤n≤60.

Such organopolysiloxanes are suitable as a wetter, and, for example, it allow a phenyl-modified silicone to be highly filled with a highly thermally conductive filler.

In the general formula (1), R¹ preferably represents a phenyl group and R² represents a methyl group.

From the viewpoint of organopolysiloxane synthesis, these groups are preferable.

The present invention provides a wetter comprising the organopolysiloxane compound described above.

By using the organopolysiloxane described above as a wetter, the thermally conductive filler can be dispersed further in the phenyl-modified silicone.

### ADVANTAGEOUS EFFECTS OF INVENTION

The inventive organopolysiloxane is useful as a silane coupling agent (wetter) that improves the dispersibility of the thermally conductive filler in the phenyl-modified silicone. Therefore, the phenyl-modified silicone composition containing the inventive organopolysiloxane suppresses viscosity of the composition and its flowability is maintained, even when it contains a large amount of the thermally conductive filler. Therefore, when the inventive organopolysiloxane is introduced into a silicone composition, it is possible to obtain a thermally conductive silicone composition in which an increase in viscosity is suppressed, even when the thermally conductive filler is highly filled.

### BRIEF DESCRIPTION OF DRAWINGS

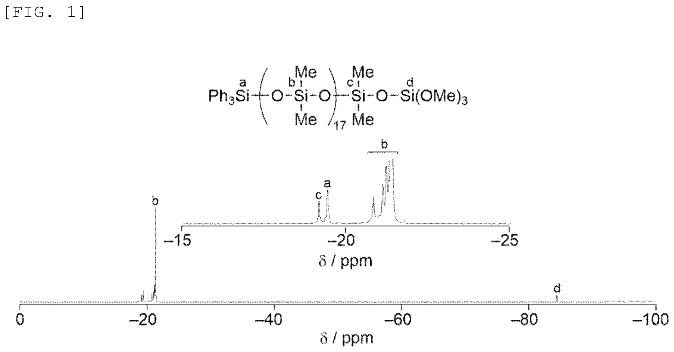

[FIG. 1] is a ²⁹Si-NMR chart of the organopolysiloxane synthesized in Example 1.

### DESCRIPTION OF EMBODIMENTS

The present inventors have explored an organopolysiloxane suitable for a wetter that allows a resin material, particularly phenyl-modified silicone, to be highly filled with a highly thermally conductive filler, have found that the organopolysiloxane represented by the following general formula (1) is useful for this purpose, and have completed the present invention.

That is, the present invention is an organopolysiloxane compound represented by the following general formula (1), 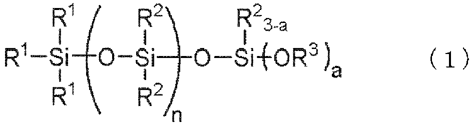 wherein R¹ independently represents an aromatic hydrocarbon group having 6 to 10 carbon atoms; R² independently represents an alkyl group having 1 to 10 carbon atoms; R³ represents an alkyl group having 1 to 4 carbon atoms; "a" represents 2 or 3; and "n" represents an integer satisfying 2≤n≤60.

Hereinafter, the present invention will be described in detail.

In the general formula (1), R¹ represents independently a monovalent aromatic hydrocarbon group having 6 to 10 carbon atoms. Specific examples of R¹ include aryl groups, such as a phenyl group, a tolyl group, a xylyl group, and a mesityl group, and among these, a phenyl group is preferable from the viewpoint of ease of synthesis.

In the general formula (1), R² represents an alkyl group having 1 to 10 carbon atoms, more preferably 1 to 5, and further preferably 1 to 3. Examples of R² include, alkyl groups, such as a methyl group, an ethyl group, propyl group, an isopropyl group, a butyl group, a tert-butyl group, a pentyl group, a hexyl group, an octyl group, a nonyl group, and a decyl group, and among these, a methyl group and an ethyl group are particularly preferable from the viewpoint of ease of synthesis of the inventive organopolysiloxane compound and economic efficiency.

In the above general formula (1), R³ is an alkyl group having 1 to 4 carbon atoms. Examples of R³ include alkyl groups, such as a methyl group, an ethyl group, a propyl group, an isopropyl group, a butyl group, and a tert-butyl group. Among these, a methyl group and an ethyl group are particularly preferable from the viewpoint of the hydrolysis property of the inventive organopolysiloxane compound. Furthermore, in the above general formula (1), "a" represents an integer of 2 or 3, but is preferably 3 from the viewpoint of ease of synthesis of the inventive organopolysiloxane compound and economic efficiency.

In the general formula (1), "n" represents an integer satisfying 2≤n≤60, more preferably 9≤n≤30, and further preferably 12≤n≤18. If "n" is outside the above range, compatibility with the phenyl-modified silicone decreases significantly, which is not preferable.

Specific examples of the organopolysiloxanes represented by the general formula (1) above include the following compounds, but are not limited thereto. In the following formulae shown below, "Me" represents a methyl group and "Ph" represents a phenyl group.

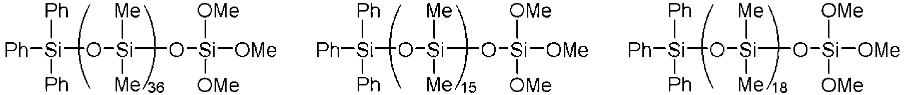

The organopolysiloxane represented by the general formula (1) above can be synthesized, for example, according to the following chemical equation.

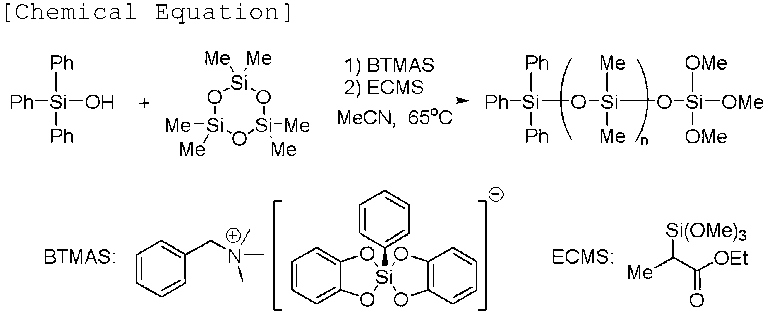

"n" in the equation was identified by ²⁹Si-NMR.

The organopolysiloxane compound represented by the general formula (1) above is synthesized by heating and stirring triarylsilanol and hexamethylcyclotrisiloxane (hereinafter sometimes referred to as cyclic siloxane) in an acetonitrile solvent in the presence of bis(1,2-benzenediolate)phenylsilicate benzyltetramethylammonium salt (BTMAS, in the above equation) as a catalyst, and then reacting with ethyl 2-(trimethoxysilyl)propionate (ECMS, in the above equation) as a reaction terminator. A polar solvent, such as acetonitrile (MeCN) or N,N-dimethylformamide (DMF), is preferable as the solvent for this reaction. The reaction temperature is usually 60 to 65°C, and the reaction time is about 2 hours for each step.

By changing equivalent weight of the cyclic siloxane relative to the triarylsilanol, the length (n) of the main chain of the organopolysiloxane compound, i.e., the degree of polymerization, can be adjusted.

The obtained organopolysiloxane exhibits high solubility in phenyl-modified silicone.

### EXAMPLE

Hereinafter, the present invention will be specifically described below with reference to Examples, but the present invention is not limited thereto. In the following Examples, kinematic viscosity is a value measured at 25°C using a Canon-Fenske viscometer described in JIS Z 8803:2011. The refractive index is a value of n_{D} measured at 25°C using an Abbe refractometer described in JIS K 0062:1992. In the following formulae, "Me" represents a methyl group and "Ph" represents a phenyl group.

### [Example 1]

A 500 mL round separable flask was equipped with a stirrer, a thermometer, and a coiled condenser via a four-neck separable cover. Cyclic siloxane (201.2 g, 0.904 mol) and acetonitrile (100 g) were added to the separable flask, and the mixture was heated and stirred at 65°C to dissolve the cyclic siloxane. After the cyclic siloxane was completely dissolved, triphenylsilanol (50 g, 0.181 mol) and BTMAS (426.8 mg, 0.0904 mmol) were added, and the reaction solution was heated and stirred at 65°C for 2 hours. The progress of the reaction was monitored by ¹H-NMR spectroscopy, and after confirming that the cyclic siloxane signal had disappeared, ECMS (80.4 g, 0.362 mol) was added as a reaction terminator, and the solution was heated and stirred for an additional 2 hours at 65°C. After confirming that the peak corresponding to silanol had disappeared by infrared spectroscopy, methanol was added to the reaction solution, and the solution was heated and stirred for an additional 1 hour at 65°C. After returning the reaction solution to room temperature, the solution was washed with methanol and the oil layer was extracted. Solvent and low molecular weight siloxane contained in the resulting oil layer were removed under reduced pressure to obtain 178.7 g (yield: 71%) of an organopolysiloxane compound. This compound was a colorless, transparent liquid with a kinematic viscosity of 35 mm²·s⁻¹ and a refractive index of 1.44. ²⁹Si-NMR spectrum analysis revealed that it had the following structure (see Figure 1). 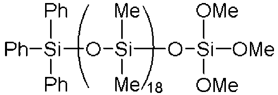 ²⁹Si-NMR spectrum (99.37 MHz, CDCl₃, 25°C): δ= -19.2 (SiMe₂), -19.5 (SiPh₃) -20.8 to -21.8 (SiMe₂), -84.8 (Si(OMe)₃).

### [Example 2]

An organopolysiloxane compound was obtained in the same manner as above, except that 10 equivalents of cyclic siloxane relative to triphenylsilanol were used. This compound was a colorless, transparent liquid with a kinematic viscosity of 64 mm²·s⁻¹ and a refractive index of 1.42. Furthermore, ²⁹Si-NMR spectrum analysis revealed that it had the following structure. 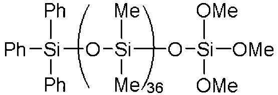 ²⁹Si-NMR spectrum (99.37 MHz, CDCl₃, 25°C): δ= -19.2 (SiMe₂), -19.5 (SiPh₃) -20.8 to -21.8 (SiMe₂), -84.8 (Si(OMe)₃).

### [Example 3]

An organopolysiloxane compound was obtained in the same manner as above, except that 3 equivalents of phenyl-modified cyclic siloxane relative to trimethylsilanol were used. This compound was a colorless, transparent liquid with a kinematic viscosity of 61 mm²·s⁻¹ and a refractive index of 1.46. Furthermore, ²⁹Si-NMR spectrum analysis revealed that it had the following structure. 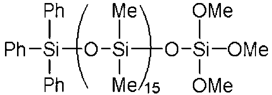 ²⁹Si-NMR spectrum (99.37 MHz, CDCl₃, 25°C): δ= -19.2 (SiMe₂), -19.5 (SiPh₃) -20.8 to -21.8 (SiMe₂), -84.8 (Si(OMe)₃).

### [Compatibility Test]

When the following organosiloxane (B-5) is dispersed in phenyl-modified silicone at a concentration of 25%, clouding and layer separation occur. However, when the phenyl-modified organosiloxane (B-4) is dispersed under the same conditions as above, clouding nor layer separation does not occur. On the other hand, when the novel organosiloxanes of Examples 1 to 3 above are dispersed under similar conditions, cloudiness occurs but no layer separation occurs. Therefore, it can be said that the novel organosiloxanes above exhibit compatibility with phenyl-modified silicones, although not to the same extent as the phenyl-modified organosiloxane (B-4).

The compositions of Examples 4 to 9 and Comparative Examples 1 to 5 were obtained by mixing the components (A) to (C) described below according to the composition ratios shown in Tables 1 and 2.

### [Example 4]

A thermally conductive phenyl-modified silicone composition was obtained by mixing A-1 as the component (A), B-1 as the component (B), and the components (C). Mixing was carried out by placing a plastic container containing weighed components (A) to (C) in a planetary centrifugal mixer (product name: Thinky Mixer, manufactured by THINKY Corporation) at room temperature at 2,000 rpm for 1 minute twice. The resulting mixture was then cooled to room temperature and the viscosity was measured.

### [Example 5]

A thermally conductive phenyl-modified silicone composition was prepared in the same manner as in Example 4, except that the component (B) was changed from B-1 to B-2, and the viscosity was measured.

### [Example 6]

A thermally conductive phenyl-modified silicone composition was prepared in the same manner as in Example 4, except that the component (B) was changed from B-1 to B-3, and the viscosity was measured.

### [Comparative Example 1]

A composition of Comparative Example 1 was prepared in the same manner as in Example 4, except that the component (B) was changed from B-1 to B-4, and the viscosity was measured.

### [Comparative Example 2]

A composition of Comparative Example 2 was prepared in the same manner as in Example 4, except that the component (B) was changed from B-1 to B-5, and the viscosity was measured.

### [Comparative Example 3]

A composition of Comparative Example 3 was prepared in the same manner as in Example 4, except that the component (B) was changed from B-1 to B-6, and the viscosity was measured.

### [Example 7]

A thermally conductive phenyl-modified silicone composition was prepared in the same manner as in Example 4, except that the component (A) was changed from A-1 to A-2, and the viscosity was measured.

### [Example 8]

A thermally conductive phenyl-modified silicone composition was prepared in the same manner as in Example 4, except that the component (A) was changed from A-1 to A-3, and the viscosity was measured.

### [Example 9]

A thermally conductive phenyl-modified silicone compositions were prepared in the same manner as in Example 4, except that compositions and amounts of the component (C) were changed (C-1 was changed to C-4), and the viscosity was measured.

### [Comparative Example 4]

A composition of Comparative Example 4 was prepared in the same manner as in Example 4, except that A-2 was added as the component (A) in addition to A-1, and that the component (B) was not added, and the viscosity was measured.

### [Comparative Example 5]

A composition of Comparative Example 5 was prepared in the same manner as in Example 4, except that the component (B) was not added and that the amount of the component (C) was changed, and the viscosity was measured.

### [(A) Organosiloxane]

A-1: Organosiloxane represented by the following formula and having a kinematic viscosity of 700 mm²·s⁻¹.

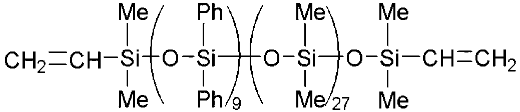

A-2: Phenyl-modified organosiloxane represented by the following formula and having a kinematic viscosity of 380 mm²·s⁻¹.

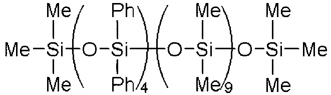

A-3: A phenyl-modified organosiloxane represented by the following formula and having a kinematic viscosity of 2,000 mm²·s⁻¹.

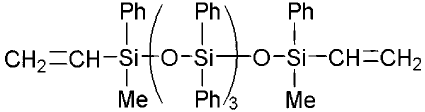

### [(B) Wetter]

B-1: Organosiloxane synthesized in Example 1 and represented by the following formula.

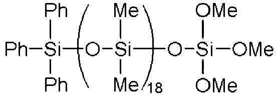

B-2: Organosiloxane synthesized in Example 2 and represented by the following formula.

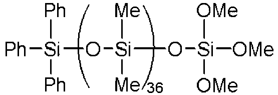

B-3: Organosiloxane synthesized in Example 3 and represented by the following formula.

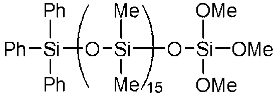

B-4: Organosiloxane represented by the following formula.

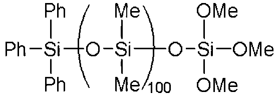

B-5: Organosiloxane represented by the following formula.

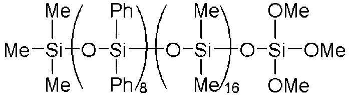

B-6: Organosiloxane represented by the following formula.

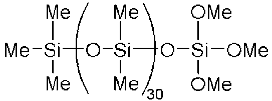

### [(C) Thermally conductive filler]

C-1: Spherical alumina powder (average particle diameter 45 µm)
C-2: Spherical alumina powder (average particle diameter 10 µm)
C-3: Irregular alumina powder (average particle diameter 2 µm)
C-4: Irregular aluminum nitride powder (average particle diameter 30 µm)

### [Method for Manufacturing]

The components (A) to (C) were mixed according to the following to obtain compositions of the Examples and Comparative Examples. A plastic container containing the components (A) to (C), each weighed and set according to compositions (weight) shown in Tables 1 and 2, was placed in a planetary centrifugal mixer (product name: Thinky Mixer, manufactured by THINKY Corporation) and the components were mixed at room temperature at 2,000 rpm for 1 minute twice. The resulting mixture was then cooled to room temperature.

### [Test Methods]

The properties of the obtained compositions were measured using the following test methods, and the results are shown in the tables below.

### [Viscosity Measurement]

The viscosity of the resulting composition was measured at a rotation speed of 10 s⁻¹ using a viscosity/viscoelasticity measuring apparatus (product name: MARS40, Thermo Fisher Scientific Co., Ltd.). The measurement was carried out at 23°C, using a parallel plate, and with a gap of 0.5 mm.

**[Table 1]**

| | Component | | Example 4 | Example 5 | Example 6 | Comparative Example 1 | Comparative Example 2 | Comparative Example 3 |
|---|---|---|---|---|---|---|---|---|
| Composition | Component (A) (g) | A1 | 11 | 11 | 11 | 11 | 11 | 11 |
| | Component (B) (g) | B1 | 2.5 | | | | | |
| | | B2 | | 2.5 | | | | |
| | | B3 | | | 2.5 | | | |
| | | B4 | | | | 2.5 | | |
| | | B5 | | | | | 2.5 | |
| | | B6 | | | | | | 2.5 |
| | Component (C) (g) | C1 | 62.7 | 62.7 | 62.7 | 62.7 | 62.7 | 62.7 |
| | | C2 | 31.3 | 31.3 | 31.3 | 31.3 | 31.3 | 31.3 |
| | | C3 | 31.3 | 31.3 | 31.3 | 31.3 | 31.3 | 31.3 |
| Filler filling rate (vol.%) | | | 70 | 70 | 70 | 70 | 70 | 70 |
| Viscosity (10⁻¹, Pa·s) | | | 61 | 77 | 107 | 150 | 180 | 102 |

**[Table 2]**

| | Component | | Example 7 | Example 8 | Example 9 | Comparative Example 4 | Comparative Example 5 |
|---|---|---|---|---|---|---|---|
| Composition | Component (A) (g) | A1 | | | 11 | 11 | 11 |
| | | A2 | 11 | | | 2.5 | |
| | | A3 | | 11 | | | |
| | Component (B) (g) | B1 | 2.5 | 2.5 | 2.5 | | |
| | Component (C) (g) | C1 | 62.7 | 62.7 | | 62.7 | 51.5 |
| | | C2 | 31.3 | 31.3 | 28.2 | 31.3 | 25.5 |
| | | C3 | 31.3 | 31.3 | 28.2 | 31.3 | 25.5 |
| | | C4 | | | 56.4 | | |
| Filler filling rate (vol.%) | | | 70 | 70 | 70 | 70 | 70 |
| Viscosity (10⁻¹, Pa·s) | | | 36 | 104 | 140 | 280 | 300 |

The results in Tables 1 and 2 demonstrated that the phenyl-modified silicone compositions containing the inventive organopolysiloxane had a reduced viscosity, enabling high filling of the thermally conductive filler. In particular, despite using high-viscosity A-3 as the component A in Example 8 and despite changing the component C in Example 9, the increase in viscosity of the composition was more suppressed than in Comparative Example 2.

On the other hand, when B-4 (Comparative Example 1) that does not fall within the scope represented by the general formula (1) or B-5 (Comparative Example 2) that does not have a triphenylsiloxy group at the molecular chain terminal was used, the viscosity of the composition increased. Furthermore, when compositions did not contain the component (B) (Comparative Examples 4 and 5) their viscosity increased significantly.

On the other hand, when B-6 that does not have a phenyl group was used (Comparative Example 3), the viscosity of the composition did not increase.

The present description includes the following embodiments.
[1] An organopolysiloxane compound represented by the following general formula (1), 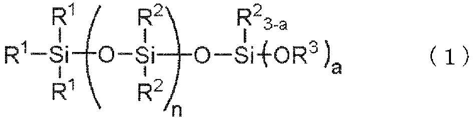 wherein R¹ independently represents an aromatic hydrocarbon group having 6 to 10 carbon atoms; R² independently represents an alkyl group having 1 to 10 carbon atoms; R³ represents an alkyl group having 1 to 4 carbon atoms; "a" represents 2 or 3; and "n" represents an integer satisfying 2≤n≤60.
[2] The organopolysiloxane compound of the above [1], in the general formula (1), wherein R¹ represents a phenyl group and R² represents a methyl group.
[3] A wetter comprising the organopolysiloxane compound of the above [1] or [2].

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. An organopolysiloxane compound represented by the following general formula (1), 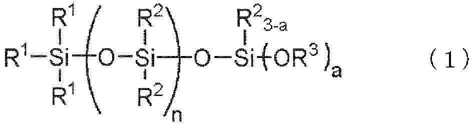 wherein R¹ independently represents an aromatic hydrocarbon group having 6 to 10 carbon atoms; R² independently represents an alkyl group having 1 to 10 carbon atoms; R³ represents an alkyl group having 1 to 4 carbon atoms; "a" represents 2 or 3; and "n" represents an integer satisfying 2≤n≤60.

2. The organopolysiloxane compound according to claim 1, wherein R¹ represents a phenyl group and R² represents a methyl group.

3. A wetter comprising the organopolysiloxane compound according to claim 1 or 2.
